# EUROPEAN PATENT APPLICATION

(11) **EP 2 196 812 A1**
(43) Date of publication of application: **16.06.2010**
(21) Application number: 08171071.7
(22) Date of filing: 09.12.2008
(51) Int. Cl.: G01R 31/02

(54) **Monitoring device for detecting earth faults**

(71) Applicant: WaveTech Sweden AB, 351 96 Växjö (SE)
(72) Inventor: Corfitsson, Olle, 256 62 Helsingborg (SE)
(74) Representative: Hjalmarsson, Magnus Axel

(57) **Abstract**

The present disclosure relates to a monitoring device for detecting earth faults 12 in a power distribution system connected to a power transformer 3. The system is a non-effectively earthed system, and the device includes an input terminal 22, receiving a measured signal corresponding to the neutral point voltage of the power distribution system, a neutral point peak detector,23, 25 providing a measure, Uₘₐₓ, of the maximum measured signal, and a measurement value converter 29 adapted for transmitting the measure to a control station. This device provides a good indication that a temporary earth fault has occurred.

## Description

### Technical field

The present disclosure relates to a monitoring device for detecting earth faults in a power distribution system connected to a power transformer, where the system is a non-effectively earthed system.

### Background

Earth faults sometimes occur in buried distribution system cables such as three phase medium voltage cables. Before such faults become permanent and a part of the system must be disconnected, temporary faults often occur a number of times. By detecting such temporary faults, it is possible to predict breakdown and undertake necessary measures to minimize damage. There exist systems capable of detecting earth faults. However, those systems are usually quite complex, sometimes relying on frequency analysis of measured signals.

### Summary

An object of the present disclosure is therefore to obtain a simple but yet reliable monitoring device, capable of detecting an earth fault.

This object is achieved by means of a monitoring device as defined in claim 1. More particularly, a monitoring device of the initially mentioned kind then involves an input terminal, receiving a measured signal corresponding to the instantaneous neutral point voltage of the power distribution system, a neutral point peak detector providing a measure of the maximum measured signal, and a measurement value converter adapted for transmitting the measure to a control station.

A temporary earth fault in a non-effectively earthed system will, very briefly, generate a voltage transient in the neutral point of the system. By detecting the peak value of the neutral point voltage, and transferring a corresponding signal to an operator as a warning signal, the monitoring device can facilitate detection of earth faults, often in good time before a cable breaks down permanently. Yet, this monitoring device is very simple and cost-efficient.

This device is capable also of detecting resistive earth faults. Further a narrowband connection to a control station may be used, as a fault can be indicated by means of a current.

The neutral point peak detector may comprise a rectifier, rectifying the measured signal, and a capacitor storing the rectified value as the maximum measured signal. This provides a very simple peak detector. The capacitor, together with the input impedance of the measurement value converter, may form an RC-circuit, discharging the capacitor. This allows the capacitor voltage to fall to a low value after providing the warning signal. Thereby a subsequent earth fault occurrence may be detected. The RC-circuit may have a time constant e.g. in the range of 5-100 seconds.

The monitoring device may further comprise a signal transformer, the secondary side of which is connected to the input terminal, and the primary side of which is adapted to be connected to a neutral point of the power transformer. This allows the monitoring device to be connected to high voltage systems. For a low-voltage system however, the input terminal may in principle be connected to a neutral point of the power transformer.

If the power transformer has a Δ-configuration winding, the monitoring device may comprise a set of signal transformers forming an open-Δ configuration, the secondary side of which is connected to the input terminal, and the primary side of which is adapted to be connected to the phases of the power transformer.

### Brief description of the drawings

Fig 1 illustrates a power distribution system where the monitoring device of the present disclosure may be used.
Fig 2 shows a power distribution system where an earth fault occurs.
Fig 3 illustrates a monitoring device.
Fig 4 shows a Δ-connected power transformer with a set of signal transformers forming an open-Δ configuration.
Fig 5 illustrates Δ-connected power transformer with a neutral point generator.
Fig 6 shows a Y-connected power transformer with a resistive earth connection.

### Detailed description

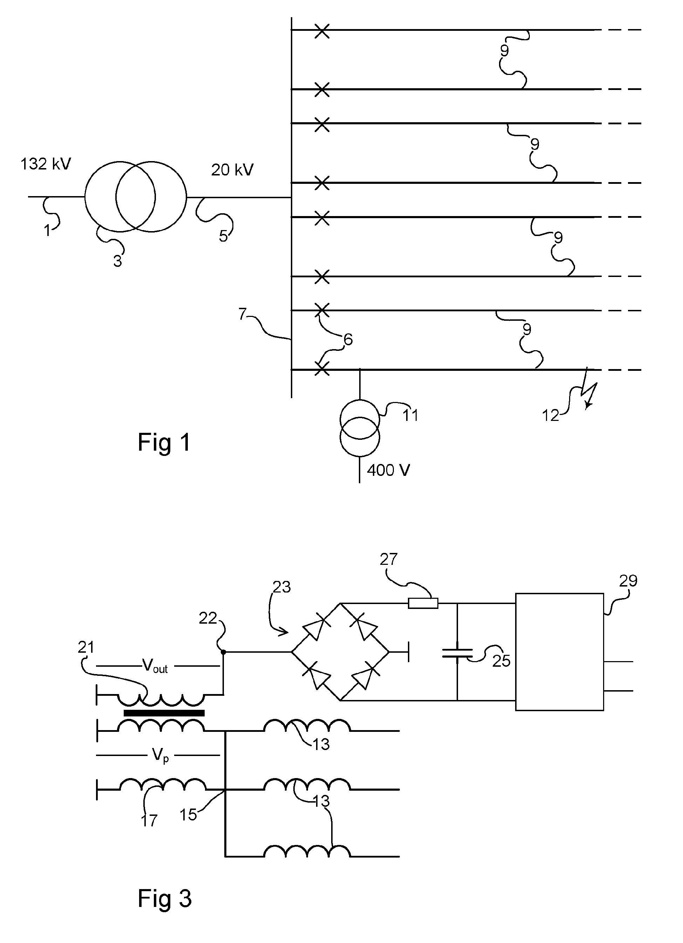

Fig 1 illustrates a power distribution system where the monitoring device of the present disclosure may be used. A high voltage grid 1, in the illustrated case 132kV, is connected via a power transformer 3, to a medium voltage distribution system 5, which in the illustrated case runs with a 20kV voltage. The medium voltage distribution system 5 has a busbar 7, with a number of, usually open, feeding loops 9. Each feeding loop typically has a plurality of substation power transformers 11 connected thereto, providing for instance 400V power to houses, etc.

The feeding loops may often comprise buried insulated cables. In three-phase systems, the buried cables may include both three-phase cables, having a common enclosure, and sets of three individual single-phase cables. One problem associated with such buried cables is earth faults, which occur when the insulation becomes deteriorated due to ageing and/or damage. Often, the insulation may have imperfections which may cause a short-circuit between one phase of the cable and earth. Usually, in such cases, a plurality of temporary earth faults 12 with very short durations (typically 0.5-2 ms), sometimes called re-striking earth faults, occur over a number of days or weeks before the short circuit becomes permanent and the feeding loop must be disconnected. Since the temporary earth faults are so short in duration, the breaker 6 of the feeding loop with the fault does not usually disconnect the feeding loop.

Thus, if the preceding earth faults with short duration can be detected, the grid operator can undertake necessary measures before the cable breaks down permanently. Thereby the breakdown can be prevented or the damage caused by the breakdown can be minimized.

In the following there will be described a simple but yet reliable monitoring device that is able of detecting temporary earth faults, such that a power system operator can undertake different actions so as to minimize the damage caused by the malfunctioning cable.

The monitoring device may be used in so-called non-effectively earthed systems. By non-effectively earthed systems is meant systems where the neutral point of the system is more or less floating with respect to earth. This term is equivalent with what is defined as non-effectively grounded systems in IEEE Std C62.92.1-2000.

In a non-effectively earthed system there can be a neutral point-to-earth voltage. Usually, this means a neutral point in a star configuration. As will be shown however, a neutral point can be generated also for a Δ-configuration, and in principle also for a single phase configuration.

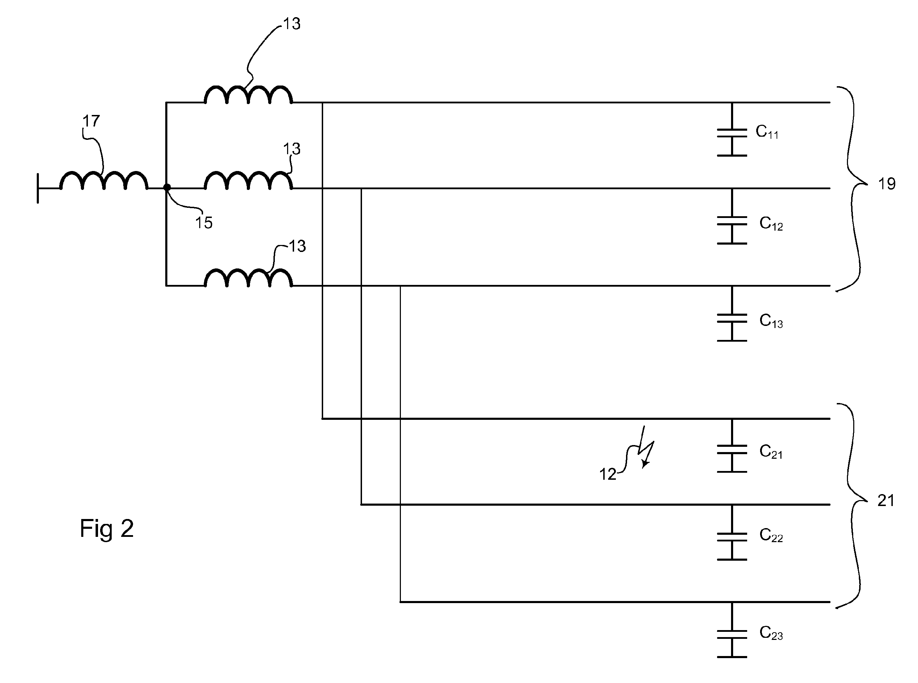

Fig 2 shows a power distribution system where an earth fault 12 occurs. Illustrated in fig 2 are the secondary windings 13 (medium voltage side) of the power transformer (cf. 3 fig 1). The windings 13 are connected in a star configuration. The neutral voltage connection point 15 of the configuration is not fully floating and is connected to earth via a Petersen coil 17. To simplify the description, only two medium voltage three phase cables 19, 21 are shown connected to the power transformer. Each phase of each cable 19, 21 has a certain capacitance (C₁₁, C₁₂, etc,) to earth depending on the length of the cable.

In order to comply with different safety regulations, the reactance of the Petersen coil 17 is tuned vis-à-vis the joint capacitance of the system as is well known per se.

Fig 3 illustrates a monitoring device. The device includes a signal transformer 21 having a primary side connected to the neutral point 15 of the power transformer (cf. 3, fig 1). The secondary side of the signal transformer 21 provides an AC voltage Vₒᵤₜ, to a peak detector input terminal 22, that is proportional to an AC voltage Vp over the neutral-to earth connection.

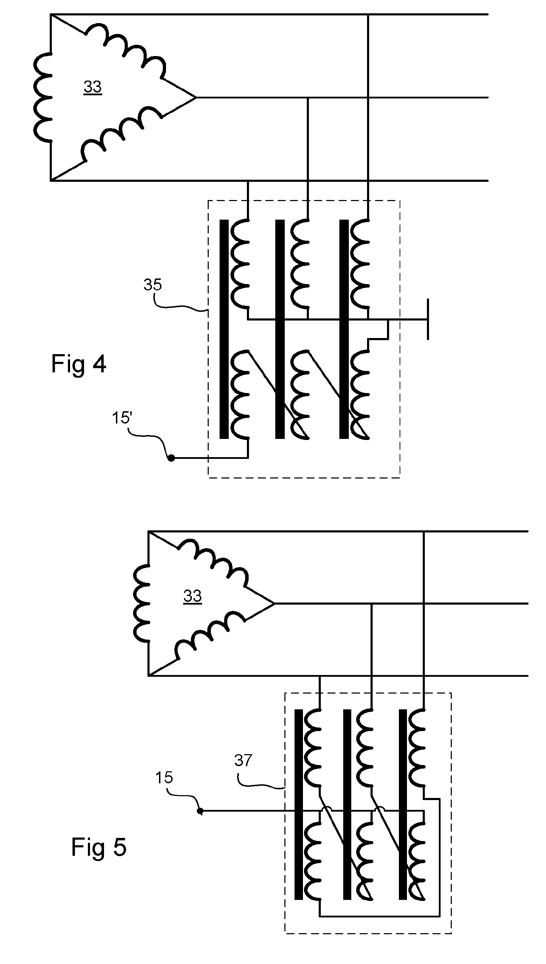

A peak voltage detector includes a rectifier 23 and a capacitor 25, and has an input terminal 22. The output from the signal transformer 21 is rectified by means of a rectifier 23, and the rectified signal charges a capacitor 25 via a resistor 27. The resistor 27 (e.g. 10Ω) limits the current through the signal transformer 21 to protect the latter from excessive currents. The capacitor is charged to the peak voltage of the signal transformer's 21 secondary side. An alternative solution for obtaining the neutral point voltage for measurement purposes will be described in connection with fig 4. In a system with relatively low system voltage, it would be conceivable to connect the input terminal 22 directly to the neutral point 15.

The thereby stored peak voltage may be applied to a measurement value converter 29 which provides e.g. an output current in the interval 0-10 mA in response to the applied voltage. The measurement value converter 29 has a high impedance (MΩ range), such that it forms, with the capacitor 25, an RC-circuit with a time constant which may be about 5-100 seconds. After some time therefore, the capacitor voltage is reset to a low level, such that a subsequent earth fault can be detected.

Returning to fig 2, when an earth fault 12 occurs, the entire capacitive system of the network is quickly recharged, usually in about 0.5-2 milliseconds. Consider a case where the first phase (having the capacitance C₂₁ to earth) of a cable 21 experiences a temporary earth fault 12. This usually occurs close to the peak voltage of an AC half period of the phase. The following table illustrates the voltages over the system capacitances and the neutral point the instant before and after the fault occurs, where the value 1 is the peak voltage.

| | Before | After |
|---|---|---|
| C₁₁, C₂₁ | 1 | 0 |
| C₁₂, C₂₂ | -0.5 | -1.5 |
| C₁₃, C₂₃ | -0.5 | -1.5 |
| Neutral point 15 | 0 | 1 |

This results, in a system with a connected Petersen coil, in an oscillation of the circuit consisting of the capacitive system and the Petersen coil. As can be seen, when the temporary earth fault occurs, the potential at the neutral point 15 quickly rises to almost the AC peak voltage, inducing an oscillation that decays depending on the attenuation in the power system.

In a case where a resistive connection to earth is used, as will be illustrated, no oscillation, but a single pulse, is experienced in the neutral point 15.

In any case, the monitoring device of the present disclosure picks up the peak value of the neutral point voltage and provides a fault signal from the measurement value converter 29 that may be connected to a central operator system where a suitable indication may be given, indicating that a temporary earth fault has occurred at a cable or another component connected to the monitored power transformer.

Even though the monitoring device of the present disclosure is primarily intended for detecting low-resistance earth faults in buried cables, the device can also be used for detecting comparatively high-resistive faults e.g. in overhead lines. For instance, if a branch of a tree touches an overhead line phase, this may cause an earth fault even though the tree itself presents a resistance which limits the earth fault current. The detected neutral point peak voltage will be lower, but still provides an indication that a fault has occurred.

Fig 4 shows a Δ-connected power transformer 33 with a set of signal transformers forming an open Δ-transformer configuration 35. A Δ-configured power transformer 33 itself does not provide a readily accessible neutral point. However, the neutral point may be defined by using set of signal transformers forming an open Δ-transformer configuration 35 having a primary γ-side and a secondary open Δ-side, where Y-side terminals are connected to the busbar phases. The open Δ-side will provide a neutral point 15' for measurement purposes, where the neutral point voltage can be measured in the same way as does the signal transformer 21 shown in connection with fig 3. An open Δ-configuration 35 of this type could in principle also be used together with a γ-configured power transformer (cf. 13, fig 3), for instance if its neutral point is not readily accessible.

Another option for a Δ-configured power transformer 33 is illustrated in fig 5. In this case, a zigzag earthing transformer 37, which is known per se, is used to obtain a neutral point 15. This neutral point 15 allows measurements via a signal transformer (cf. 21, fig 3). Additionally, a Petersen coil or a similar device can be connected between the neutral point 15 of the zigzag earthing transformer 37 and earth in order to comply with regulations etc.

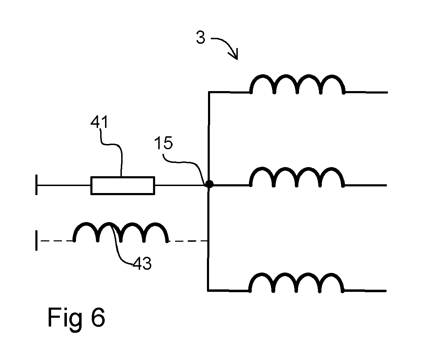

In the example given in fig 3, the neutral point voltage is measured over a Petersen coil. Fig 6 shows another configuration where a γ-connected power transformer 3 has a resistive earth connection. Then a resistor 41 is connected between the neutral point 15 and earth. Optionally, a reactance 43 may be connected in parallel with the resistor 41.

The invention is not restricted to the illustrated embodiment and may be varied in different ways within the appended claims.

For instance, even if a three-phase system is shown it is in principle possible to realise a similar detector for a single-phase system. In such a case, a mid-point voltage of a single phase power transformer winding constitutes the neutral point voltage.

Further, even though the above disclosure uses a signal transformer to obtain the measured signal, thereby achieving galvanic insulation from the monitored system, it is possible in some cases to connect the monitoring device directly to the neutral point. This particularly applies to low voltage systems.

The illustrated device can handle peaks of both polarities. In principle, it could be replaced by two separate peak detectors, one for each polarity.

## Claims

1. Monitoring device for detecting earth faults (12) in a power distribution system connected to a power transformer (3), the system being a non-effectively earthed system, the device **characterised by**:
an input terminal (22) receiving a measured signal corresponding to the neutral point voltage of the power distribution system
a neutral point peak detector (23, 25) providing a measure, Uₘₐₓ, of the maximum measured signal, and
a measurement value converter (29) adapted for transmitting the measure to a control station.

2. A monitoring device according to claim 1, wherein the neutral point peak detector comprises a rectifier (23), rectifying the measured signal, and a capacitor (25) storing rectified value as the measure Uₘₐₓ.

3. A monitoring device according to claim 2, wherein the capacitor (25), together with the input impedance of the measurement value converter (29), forms an RC-circuit, discharging the capacitor.

4. A monitoring device according to claim 3, wherein the RC-circuit has a time constant in the range of 5-100 seconds.

5. A monitoring device according to any of the preceding claims, further comprising a signal transformer (21), the secondary side of which is connected to the input terminal (22), and the primary side of which is adapted to be connected to a neutral point of the power transformer (3).

6. A monitoring device according to any of claims 1-4, wherein the input terminal (22) is connected to a neutral point of the power transformer (3).

7. A monitoring device according to any of claims 1-4, further comprising a set of signal transformers forming an open A configuration (35), the secondary side of which is connected to the input terminal (22), and the primary side of which is adapted to be connected to the phases of the power transformer (3).
